# EUROPEAN PATENT APPLICATION

(11) **EP 3 236 502 A1**
(43) Date of publication of application: **25.10.2017**
(21) Application number: 15870122.7
(22) Date of filing: 27.03.2015
(51) Int. Cl.: H01L 27/32

(54) **ORGANIC LIGHT-EMITTING DIODE DISPLAY DEVICE**

(30) Priority: 18.12.2014 US 201462094033 P; 30.01.2015 KR 20150015518
(71) Applicant: LG ELECTRONICS INC., Yeongdeungpo-Gu Seoul 150-721 (KR)
(72) Inventor: KIM, Sangcheon, Seoul 137-893 (KR); LEE, Hyunho, Seoul 137-893 (KR); SUNG, Jinwoo, Seoul 137-893 (KR)
(74) Representative: Katérle, Axel
(86) International application number: PCT/KR2015/003073
(87) International publication number: WO 2016/098954

(57) **Abstract**

An organic light-emitting diode display device includes a plurality of unit pixels each including a plurality of subpixels configured to implement light having different wavelength ranges. The organic light-emitting diode display device includes: a substrate comprising a thin film transistor; an organic light-emitting device electrically connected to the thin film transistor and configured to generate white light; a color filter array comprising a plurality of color filters disposed at positions corresponding to the plurality of subpixels to selectively transmit light having a wavelength range corresponding to each of the plurality of subpixels; and a quantum dot layer disposed between the organic light-emitting device and the color filter and configured to convert incident light into light having a wavelength capable of passing through the color filter.

## Description

### [Technical Field]

The present invention relates to an organic light-emitting diode display device, and more particularly, to an organic light-emitting diode display device which exhibits excellent light utilization efficiency and excellent color reproducibility due to inclusion of a quantum dot layer.

### [BACKGROUND ART]

An organic light-emitting diode display device (OLED) is a self-emissive display device that self-emits light by using an electroluminescence phenomenon that light is emitted when a current flows through an organic compound. Recently, the OLED has attracted attention because the OLED can be manufactured to be thinner and has excellent color and definition and fast response speed, as compared to a passive emission type display device such as a liquid crystal display (LCD) requiring a backlight.

Meanwhile, the OLED is classified into an RGB OLED and a white OLED according to a color implementing method.

The RGB OLED implements colors by using light-emitting diodes that respectively emit a red color, a green color, and a blue color. Since the RGB OLED directly uses light electrophotically converted in each of the light-emitting diodes, the RGB OLED has high utilization efficiency. However, the RGB OLED has limitations in that material development, structural design, and the like must be performed with respect to each of R, G, and B light-emitting diodes and a pattern forming process is complex. In addition, since the R, G, and B light-emitting diodes have different lifespans, an issue of implementing a color may occur when the RGB OLED is used for a long time.

Meanwhile, the white OLED implements a color by disposing red, green, and blue color filters on a white light-emitting diode and converting white light into red light, green light, and blue light. Since the white OLED uses a single light-emitting diode, the manufacturing thereof is simple. However, since light having the remaining wavelength ranges is not used except for necessary color light of the white light emitted from the white light-emitting diode, a finally extracted amount is small for consumed power.

### [Disclosure]

### [Technical Problem]

The purpose of the present invention is to provide an organic light-emitting diode display device which exhibits excellent light utilization efficiency and excellent color reproducibility by disposing a quantum dot layer between an organic light-emitting device and a color filter.

### [Technical Solution]

According to an embodiment, provided is an organic light-emitting diode display device including a plurality of unit pixels each including a plurality of subpixels configured to implement light having different wavelength ranges, the organic light-emitting diode display device including: a substrate comprising a thin film transistor; an organic light-emitting device electrically connected to the thin film transistor and configured to generate white light; a color filter array including a plurality of color filters configured to selectively transmit light having a wavelength range corresponding to each of the plurality of subpixels, the plurality of color filters being disposed at positions corresponding to the plurality of subpixels, respectively; and a quantum dot layer disposed between the organic light-emitting device and the color filters and configured to convert incident light into light having a wavelength capable of passing through the color filter.

In the organic light-emitting diode display device according to the present invention, incident light is used in a state of being converted into light having a wavelength range by forming a quantum dot layer, thereby improving brightness and color reproducibility of the organic light-emitting diode display device.

### [Description of Drawings]

FIG. 1 is a diagram illustrating a unit pixel configuration of an organic light-emitting diode display device according to an embodiment of the present invention.
FIG. 2 is a diagram illustrating a bottom emission organic light-emitting diode display device including three color subpixels according to an embodiment of the present invention.
FIG. 3 is a diagram illustrating a bottom emission organic light-emitting diode display device including four color subpixels according to an embodiment of the present invention.
FIG. 4 is a diagram illustrating a top emission organic light-emitting diode display device including three color subpixels according to an embodiment of the present invention.
FIG. 5 is a diagram illustrating a top emission organic light-emitting diode display device including four color subpixels according to an embodiment of the present invention.
FIG. 6 is a graph showing an emission spectrum comparison before and after light generated in an organic light-emitting device passes through a red quantum dot layer.
FIG. 7 is a graph showing an emission spectrum comparison before and after light generated in an organic light-emitting device passes through a green quantum dot layer.
FIG. 8 is a graph showing a color region of an organic light-emitting diode display device according to the present invention and a color region of an organic light-emitting diode display device of the prior art.

### [Best Mode]

Hereinafter, the embodiments disclosed in the present specification will be described in more detail with reference to the accompanying drawings. The following drawings are provided merely to help understanding of the present invention, not to limit the present invention. The shapes, sizes, ratios, angles, numbers, and the like illustrated in the accompanying drawings for describing the exemplary embodiments of the present disclosure are merely examples, and the present disclosure is not limited thereto. Like reference numerals denote like elements throughout the descriptions.

Further, in the following description, a detailed explanation of known related technologies may be omitted to avoid unnecessarily obscuring the subject matter of the present disclosure. The terms such as "including," "having," and "consist of" used herein are generally intended to allow other components to be added unless these terms are used with the term "only". Any references to singular may include plural unless expressly stated otherwise.

Components are interpreted to include an ordinary error range even if not expressly stated.

In describing the temporal relationship, such as "after", "subsequent", "next", "before", or the like, discontinuous cases also are included unless these terms are used with the term "immediately" or "directly".

Also, it will be understood that although the terms "first", "second", etc. may be used herein to describe various components, these components should not be limited by these terms. These terms are only used to distinguish one component from another. Therefore, a first component used herein may be a second component within the technical scope of the present invention.

Also, in describing the present invention, a top-bottom relationship, such as an upper portion, an upper surface, a lower portion, or a lower surface, is based on an arrangements illustrated in the drawings. That is, a direction from a substrate toward an organic light-emitting device indicates an upper portion, and a direction from an organic light-emitting device toward a substrate indicates a bottom portion.

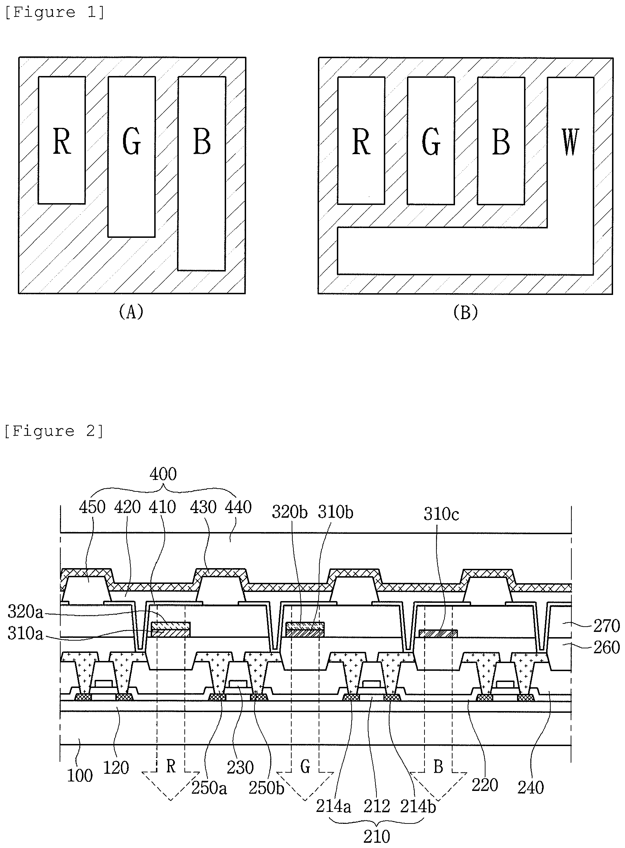

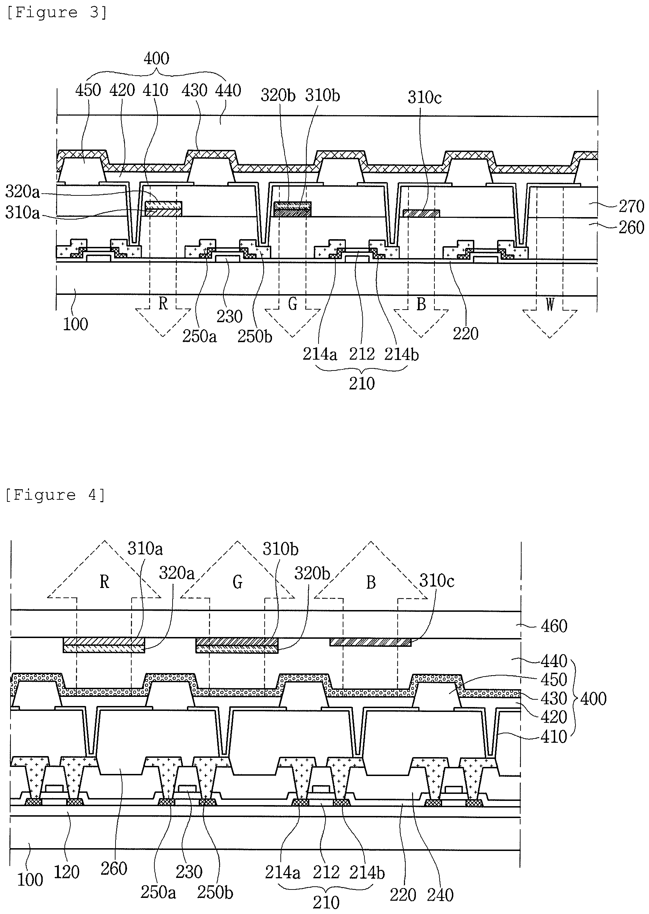

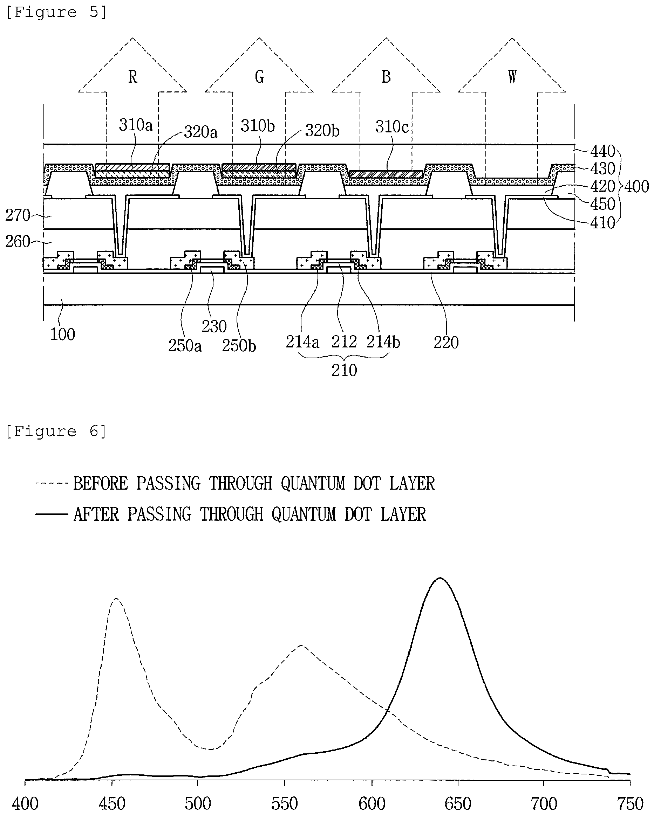

FIGS. 1 to 5 are diagrams respectively illustrating organic light-emitting diode display devices according to the present invention. Specifically, FIG. 1 is a diagram illustrating a unit pixel configuration of an organic light-emitting diode display device according to an embodiment of the present invention. FIGS. 2 and 3 are diagrams illustrating a unit pixel structure of a bottom emission organic light-emitting diode display device. FIGS. 4 and 5 are diagrams illustrating a unit pixel structure of a top emission organic light-emitting diode display device. In this case, the term "bottom emission" means that light emitted in an organic light-emitting device is emitted toward a substrate provided with a thin film transistor. The term "top emission" means that light emitted in an organic light-emitting device is emitted in a direction opposite to a substrate provided with a thin film transistor.

As shown in FIG. 1, the organic light-emitting diode display device according to the embodiment of the present invention includes a plurality of unit pixels each including a plurality of subpixels.

In the present invention, each of the unit pixels may include subpixels implementing light having different wavelength ranges, for example, a combination of a red subpixel R implementing light having a wavelength range of about 600 nm to about 700 nm, a green subpixel G implementing light having a wavelength range of about 490 nm to about 560 nm, and a blue subpixel B implementing light having a wavelength range of about 430 nm to about 480 nm, or a combination of a red subpixel R, a green subpixel G, a blue subpixel B, and a white subpixel W implementing light having a wavelength range of about 400 nm to about 700 nm.

For example, each of the unit pixels includes the red subpixel R, the green subpixel G, and the blue subpixel B as shown in (A) of FIG. 1 or the red subpixel R, the green subpixel G, the blue subpixel B, and the white subpixel W as shown in (B) of FIG. 1.

On the other hand, in the present invention, the subpixels in the unit pixel may have different sizes and/or different shapes as shown in FIG. 1. In the case of the present invention, since light emitted in an organic light-emitting device is wavelength-converted through a quantum dot layer and then is incident on color filters, amounts of light passing through the color filters are different from one another. For example, in the case of the prior art, when the numbers of R, G, and B photons of the light emitted from the organic light-emitting device are assumed to be equal to one another, since each of a red color filter, a green color filter, and a blue color filter has transmitted only light having the same color as a corresponding color filter and absorbed light having the remaining colors, each of the subpixels theoretically had a light transmission amount of about 33% with respect to an incident light amount. On the contrary, in the case of the present invention, since blue light and/or green light incident on a red subpixel or a green subpixel is wavelength-converted through a quantum dot layer and then is incident on a color filter, a light transmission amount of the red subpixel or the green subpixel is larger than a light transmission amount of a blue subpixel. As a result, when subpixels are formed to have the same size like in the organic light-emitting diode display device of the prior art, an appropriate white balance may not be implemented. Therefore, it is preferable that an appropriate white balance is implemented by adjusting each of subpixels.

For example, when each of the unit pixels includes the red subpixel, the green subpixel, and the blue subpixel, it is preferable that an area of the blue subpixel is about 1.5 times to about 3 times larger than an area of the red subpixel and is about 1.1 times to about 2 times larger than an area of the green subpixel.

In addition, when each of the unit pixels includes the red subpixel, the green subpixel, the blue subpixel, and the white subpixel, it is preferable that an area of the blue subpixel is about 1.5 times to about 3 times larger than an area of the red subpixel and is about 1.1 times to about 2 times larger than an area of the green subpixel, and an area of the white subpixel is about 1.5 times to about 3 times larger than an area of the red subpixel.

When the subpixels are formed to have the aforementioned area, an excellent white balance may be implemented. In addition, a light transmission amount may be increased, thereby improving brightness. Specifically, when the same power is consumed, white brightness may be improved by about 15%.

On the other hand, as shown in FIGS. 2 to 5, the organic light-emitting diode display device according to the embodiment of the present invention includes a substrate 100 provided with a thin film transistor (TFT), an organic light-emitting device 400, a color filter array 300, and a quantum dot layer 320.

In this case, the substrate 100 is an insulating substrate formed of a material such as glass or plastic. The TFT is disposed on the substrate 100 to drive the organic light-emitting device. The TFT includes a semiconductor layer 210, a gate electrode 230, a source electrode 250a, and a drain electrode 250b.

More specifically, as shown in FIGS. 2 to 4, the TFT may have a structure in which the semiconductor layer 210 including a source region 214a, a channel region 212, and a drain region 214b is formed on the substrate 100, a gate insulating film 220 is formed on the semiconductor layer 210, and a gate line (not shown) and the gate electrode 230 branched from the gate line are formed on the gate insulating film 220. An interlayer insulating film 240 is formed on the gate electrode 230.

Meanwhile, the source electrode 250a is branched from a data line. The drain electrode 250b is spaced apart from the source electrode 250 by a certain distance. The source electrode 250a and the drain electrode 250b respectively contact the source region 214a and the drain region 214b of the semiconductor layer 210 through contact holes formed so as to penetrate the gate insulating film 220 and the interlayer insulating film 240.

A protective film 260 is formed on the source electrode 250a and the drain electrode 250b. A contact hole is formed in the protective film 260 to expose the drain electrode 250b. In this case, a planarization film 270 may be formed on the protective film 260 if necessary. In this case, the contact hole exposing the drain electrode 250b is formed so as to penetrate the protective film 260 and the planarization film 270.

The exposed drain electrode 250b is electrically connected to a lower electrode 410 of the organic light-emitting device 400 described later. On the other hand, the drain electrode is illustrated in drawings as being directly connected to the lower electrode of the organic light-emitting device, but the present invention is not limited thereto. The lower electrode of the organic light-emitting device and the drain electrode of the TFT may be connected through a connection electrode (not shown).

Alternatively, as shown in FIGS. 3 to 5, the TFT may have a structure in which the gate electrode 230 is formed on the substrate 100, the gate insulating film 220 is formed on the gate electrode 230, and the semiconductor layer 210 including the source region 214a, the channel region 212, and the drain region 214b is formed so as to overlap the gate electrode through the gate insulating film 220. The source electrode 250a and the drain electrode 250b are spaced apart from each other by a certain distance on both sides of the semiconductor layer 210.

The protective film 260 is formed on the source electrode 250a and the drain electrode 250b. The contact hole is formed in the protective film 260 to expose the drain electrode 250b. In this case, the planarization film 270 may be formed on the protective film 260 if necessary. In this case, the contact hole exposing the drain electrode 250b is formed so as to penetrate the protective film 260 and the planarization film 270.

The exposed drain electrode 250b is electrically connected to the lower electrode 410 of the organic light-emitting device 400 described later. On the other hand, the drain electrode is illustrated in drawings as being directly connected to the lower electrode of the organic light-emitting device, but the present invention is not limited thereto. The lower electrode of the organic light-emitting device and the drain electrode of the TFT may be connected through a connection electrode (not shown).

On the other hand, as shown in FIGS. 2 to 4, a buffer layer 120 and/or a screening layer (not shown) may be additionally disposed between the substrate 100 and the TFT.

The buffer layer 120 prevents impurities present in the substrate 100 from permeating the TFT during a process and is formed all over the area of the substrate 100. Meanwhile, a material forming the buffer layer 120 may be, but is not limited to, for example, silicon oxide, silicon nitride, or the like.

On the other hand, the screening layer prevents the semiconductor layer 210 from being oxidized by light. The screening layer may be formed of a material absorbing or reflecting light. For example, the screening layer may be formed of a metal, a semiconductor material such as amorphous silicon (α-Si), a black resin, or the like.

Next, the organic light-emitting device 400 supplies light to the subpixels and includes the lower electrode 410, an organic emission layer 420, and an upper electrode 430.

The lower electrode 410 generates holes and is electrically connected to the drain electrode 250b of the TFT. The lower electrode 410 may be formed of a certain metal material such as aluminum (Al) and a transparent conductive material such as indium tin oxide (ITO). For example, in the case of the bottom emission organic light-emitting diode display device as shown in FIGS. 2 and 3, the lower electrode 410 is formed of the transparent conductive material such as ITO. In the case of the top emission organic light-emitting diode display device as shown in FIGS. 4 and 5, the lower electrode 410 is formed of the certain metal material such as Al.

On the other hand, as shown in FIGS. 2 to 5, the organic light-emitting device 400 may be disposed in each of subpixels. In this case, a bank pattern 450 for dividing the organic emission layer with respect to the subpixels may be formed on the lower electrode. In this case, the organic emission layer 420 may be formed in a region defined by the bank pattern 450.

The organic emission layer 420 generates light through hole-electron recombination. The organic emission layer 420 may be formed of an organic light-emitting material emitting fluorescence and/or phosphorescence and a dopant assisting the organic light-emitting material. A light-emitting material and a dopant material well known in the art may be used as the organic light-emitting material and the dopant, but the present invention is not particularly limited thereto. In addition, the organic emission layer 420 may be configured so as to have light-emitting characteristics as well as electron/hole transporting characteristics by using a material that has a portion exhibiting light-emitting characteristics and a functional group having electron and/or hole transporting characteristics, or by using a mixture of a light-emitting material and a transporting compound and/or a hole transporting material. In this case, since an electron/hole transporting layer does not need to be separately formed, a layer configuration of an organic light-emitting device may be simplified.

In the present invention, it is preferable that the organic emission layer 420 emits white light. More preferably, the organic emission layer 420 may emit white light obtained by mixing red light having a wavelength range of about 600 nm to about 700 nm, green light having a wavelength range of about 490 nm to about 560 nm, and blue light having a wavelength range of about 430 nm to about 480 nm.

On the other hand, as shown in FIGS. 2 to 5, the organic emission layer 420 according to the present invention may be formed in a single-layered structure and additionally include functional layers for assisting an injection and a transportation of holes or electrons between the organic emission layer 420 and the lower electrode 410 and/or between the organic emission layer 420 and the upper electrode 430.

For example, at least one functional layer for improving capability of injection and/or transportation of holes, i.e., at least one of a hole injection layer and a hole transporting layer may be additionally included between the organic emission layer 420 and the lower electrode 410. At least one functional layer for improving capability of injection and/or transportation of electrons, i.e., at least one of an electron injection layer and an electron transporting layer may be additionally included between the organic emission layer 420 and the upper electrode 430. Meanwhile, each of the hole injection layer, the hole transporting layer, the electron injection layer, and the electron transporting layer may be formed in a single layer. The hole injection layer and the hole transporting layer may be integrated in one layer, or each of the hole injection layer, the hole transporting layer, the electron injection layer, and the electron transporting layer may be formed in a multi-layered structure having two or more layers. Alternatively, the electron injection layer and the electron transporting layer may be integrated in one layer, or each of the hole injection layer, the hole transporting layer, the electron injection layer, and the electron transporting layer may be formed in a multi-layered structure having two or more layers. On the other hand, a hole injection layer material and/or a hole transporting material well known in the art may be used as materials forming the functional layers, but the present invention is not particularly limited thereto.

Next, the upper electrode 430 generates electrons and is formed on the organic emission layer 420. The upper electrode 430 may be formed of a certain metal material such as Al or a transparent conductive material such as indium tin oxide (ITO). For example, in the case of the bottom emission organic light-emitting diode display device as shown in FIGS. 2 and 3, the upper electrode 430 is formed of the certain metal material. In the case of the top emission organic light-emitting diode display device as shown in FIGS. 4 and 5, the upper electrode 430 is formed of the transparent conductive material.

On the other hand, the organic light-emitting device may further include a sealing unit for protecting the organic light-emitting device from permeation of oxygen or moisture. For example, as shown in FIGS. 2 to 5, an encapsulation layer 440 may be formed on the upper electrode 430 of the organic light-emitting device to protect display devices. The encapsulation layer 440 is illustrated in FIGS. 2 to 5 as being formed in a single layer, but the present invention is not limited thereto. The encapsulation layer 440 may also be formed in a multi-layer.

In addition, as shown in FIG. 4, an encapsulation substrate 460 for an encapsulation may be combined with the encapsulation layer 440 on the encapsulation layer 440. Materials of the encapsulation layer and the encapsulation substrate may include any material as long as a material is capable of preventing an introduction of oxygen or moisture, but is not particularly limited thereto. Sealing members generally used in the art may be used without limitation. In the case of the top emission organic light-emitting diode display device as shown in FIGS. 4 and 5, it is preferable that the encapsulation layer and the encapsulation substrate are formed of a transparent material so as to transmit light.

Next, the color filter array implements a color of each of subpixels. The color filter array includes a plurality of color filters 310a, 310b, and 310c configured to selectively transmit light having a wavelength range corresponding to each of the subpixels. Specifically, the color filter array includes a red color filter 310a transmitting red light having a wavelength range of about 600 nm to about 700 nm, a green color filter 310b transmitting green light having a wavelength range of about 490 nm to about 560 nm, and a blue color filter 310c transmitting blue light having a wavelength range of about 430 nm to about 480 nm. The red color filter, the green color filter, and the blue color filter are formed at positions corresponding to a red subpixel, a green subpixel, and a blue subpixel, respectively. Meanwhile, as shown in FIGS. 3 to 5, when a white subpixel is included in the unit pixel, a color filter is not formed at a position corresponding to the white subpixel.

The color filter array is disposed on an exit surface of the organic light-emitting device. More specifically, when the organic light-emitting device is a bottom emission type organic light-emitting device, the color filter array is disposed below the organic light-emitting device. For example, the color filter array may be disposed on the protective film 260 of the TFT as shown in FIGS. 2 and 3, but the present invention is not limited thereto. The color filter array may be disposed on a lower surface of the substrate 100 provided with the TFT.

On the other hand, when the organic light-emitting device is a top emission type organic light-emitting device, the color filter array is disposed on the organic light-emitting device. In this case, for example, the color filter array may be formed on a lower surface of the encapsulation substrate 460 as shown in FIG. 4, or be formed on the upper electrode 430 of the organic light-emitting device as shown in FIG 5, but the present invention is not limited thereto. For example, in the case of the top emission organic light-emitting device, the color filter array may be formed on the encapsulation layer 440 of the organic light-emitting device.

Next, quantum dot layers 320a and 320b convert incident light into light having a wavelength capable of passing through a color filter. The quantum dot layers 320a and 320b include a quantum dot. More specifically, the quantum dot layers include at least one of a red quantum dot layer 320a including a red quantum dot and a green quantum dot layer 320b including a green quantum dot, wherein the red quantum dot converts blue light and green light into red light and the green quantum dot converts blue light into green light. The both the red quantum dot layer and the green quantum dot layer are illustrated in drawings as being included in the quantum dot layers, but the present invention is not limited thereto. Only at least one of the red quantum dot layer and the green quantum dot may be included in the quantum dot layers.

In this case, the quantum dot is a semiconductor crystal having a size of several nanometers (nm) and a quantum confinement effect and emits light injected from a light source by converting a wavelength of the light. Since an emission wavelength of a quantum dot is changed according to a size of the quantum dot, light having a desired color may be obtained by selecting a quantum dot having an appropriate size. In the present invention, for example, a quantum dot converting blue light into red light, a quantum dot converting blue light into green light, and a quantum dot converting green light into red light may be used as the quantum dot.

For example, the quantum dot may be a particle having a single-layered structure or a multi-layered structure including at least one semiconductor crystal selected from the group consisting of CdS, CdO, CdSe, CdTe, Cd₃P₂, Cd₃As₂, ZnS, ZnO, ZnSe, ZnTe, MnS, MnO, MnSe, MnTe, MgO, MgS, MgSe, MgTe, CaO, CaS, CaSe, CaTe, SrO, SrS, SrSe, SrTe, BaO, BaS, BaSe, BaTE, HgO, HgS, HgSe, HgTe, HgI₂, AgI, AgBr, Al₂O₃, Al₂S₃, Al₂Se₃, Al₂Te₃, Ga₂O₃, Ga₂S₃, Ga₂Se₃, Ga₂Te₃, In₂O₃, In₂S₃, In₂Se₃, In₂Te₃, SiO₂, GeO₂, SnO₂, SnS, SnSe, SnTe, PbO, PbO₂, PbS, PbSe, PbTe, AlN, AlP, AlAs, AlSb, GaN, GaP, GaAs, GaSb, GaInP₂, InN, InP, InAs, InSb, In₂S₃, In₂Se₃, TiO₂, BP, Si, Ge, and combinations thereof.

On the other hand, in order to prevent aggregation of quantum dots, the quantum dot may include a capping layer on a surface thereof. The capping layer may be a ligand layer coordinate-bonded to the surface of the quantum dot and be a surface layer coated with a hydrophobic organic molecule.

For example, the capping layer may be a material layer selected from the group consisting of phosphine oxide including a nonpolar long chain alkyl group or a nonpolar aryl group, organic amine, an organic acid, a phosphonic acid, and combinations thereof. For example, the capping layer may be a material layer selected from the group consisting of tri-n-octylphosphine oxide (TOPO), a stearic acid, a palmitic acid, octadecylamine, hexadecylamine, dodecylamine, a lauric acid, an oleic acid, a hexylphosphonic acid, and combinations thereof.

Meanwhile, in the present invention, the quantum dot layers 320a and 320b may be formed by dispersing the quantum dot into a polymer resin and then curing the quantum dot and the polymer resin. In this case, the polymer resin is not particularly limited to a material as long as the material is capable of dispersing the quantum dot. For example, a radical-curable resin, a cation-curable resin, or a thermal-curable resin may be used as the polymer resin. More specifically, for example, a polyester acrylate resin, polyurethane acrylate, an epoxy acrylate resin, an epoxy resin, a silicon resin, a polychlorotrifluoroethylene resin, a polyethylene resin, a polypropylene resin, a polyvinyl alcohol resin, a polyester resin, a polystyrene resin, a polymethyl methacrylate resin, and the like may be used as the polymer resin. In addition, the polymer resin may further include monomers such as lauryl methacrylate, isobornyl acrylate, and isobornyl methacrylate. In this case, the quantum dot layers 320a and 320b may be formed as a complex of a quantum dot and a polymer resin.

On the other hand, the quantum dot layers 320a and 320b are disposed between the organic light-emitting device and the color filter array. More specifically, the red quantum dot layer 320a is disposed between the red color filter 310a and the organic light-emitting device. The green quantum dot layer 320b is disposed between the green color filter 310b and the organic light-emitting device. In this case, it is more preferable that each of the quantum dot layers 320a and 320b is formed on a surface of a corresponding color filter as shown in FIGS. 2 to 5. When a gap is formed between a color filter and a quantum dot layer, light conversion efficiency may be lowered and an issue such as a color mixture may occur.

More specifically, when the organic light-emitting device is a bottom emission type organic light-emitting device, as shown in FIGS. 2 and 3, the quantum dot layers 320a and 320b, and the color filters 310a, 310b, and 310c may be sequentially formed on the protective film 260 of the organic light-emitting device. As described above, when the quantum dot layers and the color filters are formed on the protective film 260 of the organic light-emitting device, the protective film 260 may prevent penetration of oxygen or moisture to prevent deterioration of the quantum dot layers. Accordingly, the formation of a separate barrier layer for the quantum dot layers is not required. When the organic light-emitting device is a top emission type organic light-emitting device, as shown in FIGS. 4 and 5, the quantum dot layers and the color filters may be formed on the lower surface of the encapsulation substrate 460 or the upper electrode of the organic light-emitting device. In this case, the color filters 310a, 310b, and 310c and the quantum dot layers 320a and 320b may be formed by using a pattern forming method well known in the art, for example, inkjet printing, photolithography, or soft lithography.

### [Mode for Invention]

More specifically, according to an embodiment, as shown in FIG. 2, the organic light-emitting diode display device of the present invention may be a bottom emission organic light-emitting diode display device including unit pixels each including a red subpixel, a green subpixel, and a blue subpixel. More specifically, the organic light-emitting diode display device includes a plurality of unit pixels each including the red subpixel, the green subpixel, and the blue subpixel. The organic light-emitting diode display device includes the substrate 100 provided with the TFT; the bottom emission organic light-emitting device electrically connected to the TFT and emitting white light; the color filter array disposed between the bottom emission organic light-emitting device and the TFT and including the red color filter 310a, the green color filter 310b, and the blue color filter 310c respectively disposed at positions corresponding to the red, green, and the blue subpixels; and the red quantum dot layer 320a disposed between the red color filter and the bottom emission organic light-emitting device and converting incident light into light having a wavelength capable of passing through the red color filter, and the green quantum dot layer 320b disposed between the green color filter and the bottom emission organic light-emitting device and converting incident light into light having a wavelength capable of passing through the green color filter.

According to another embodiment, as shown in FIG. 3, the organic light-emitting diode display device of the present invention may be a bottom emission organic light-emitting diode display device including unit pixels each including a red subpixel R, a green subpixel G, a blue subpixel B, and a white subpixel W. More specifically, the organic light-emitting diode display device includes a plurality of unit pixels each including the red subpixel R, the green subpixel G, the blue subpixel B, and the white subpixel W. The organic light-emitting diode display device includes the substrate 100 provided with the TFT; the bottom emission organic light-emitting device electrically connected to the TFT and emitting white light; the color filter array disposed between the bottom emission organic light-emitting device and the TFT and including the red color filter 310a, the green color filter 310b, and the blue color filter 310c respectively disposed at positions corresponding to the red, green, and the blue subpixels; and the red quantum dot layer 320a disposed between the red color filter and the bottom emission organic light-emitting device and converting incident light into light having a wavelength capable of passing through the red color filter, and the green quantum dot layer 320b disposed between the green color filter and the bottom emission organic light-emitting device and converting incident light into light having a wavelength capable of passing through the green color filter.

In addition, according to another embodiment, as shown in FIG. 4, the organic light-emitting diode display device of the present invention may be a top emission organic light-emitting diode display device including unit pixels each including a red subpixel R, a green subpixel G, and a blue subpixel B. More specifically, the organic light-emitting diode display device includes a plurality of unit pixels each including the red subpixel R, the green subpixel G, and the blue subpixel B. The organic light-emitting diode display device includes the substrate 100 provided with the TFT; the top emission organic light-emitting device electrically connected to the TFT and emitting white light; the color filter array disposed on the top emission organic light-emitting device and including the red color filter 310a, the green color filter 310b, and the blue color filter 310c respectively disposed at positions corresponding to the red, green, and the blue subpixels; and the red quantum dot layer 320a disposed between the red color filter and the top emission organic light-emitting device and converting incident light into light having a wavelength capable of passing through the red color filter, and the green quantum dot layer 320b disposed between the green color filter and the top emission organic light-emitting device and converting incident light into light having a wavelength capable of passing through the green color filter.

Furthermore, according to another embodiment, as shown in FIG. 5, the organic light-emitting diode display device of the present invention may be a top emission organic light-emitting diode display device including unit pixels each including a red subpixel R, a green subpixel G, a blue subpixel B, and a white subpixel W. More specifically, the organic light-emitting diode display device includes a plurality of unit pixels each including the red subpixel R, the green subpixel G, the blue subpixel B, and the white subpixel W. The organic light-emitting diode display device includes the substrate 100 provided with the TFT; the top emission organic light-emitting device electrically connected to the TFT and emitting white light; the color filter array disposed on the top emission organic light-emitting device and including the red color filter 310a, the green color filter 310b, and the blue color filter 310c respectively disposed at positions corresponding to the red, green, and the blue subpixels; and the red quantum dot layer 320a disposed between the red color filter and the top emission organic light-emitting device and converting incident light into light having a wavelength capable of passing through the red color filter, and the green quantum dot layer 320b disposed between the green color filter and the top emission organic light-emitting device and converting incident light into light having a wavelength capable of passing through the green color filter.

When quantum dot layers are formed between an organic light-emitting device and a color filter like in the present invention, as light included in the organic light-emitting device is converted into light having a wavelength capable of passing through the color filter, light utilization efficiency may be increased, thereby implementing high brightness by using small power. In addition, since a quantum dot having a small full width at half maximum (FWHM) is used, excellent color reproducibility may be implemented as compared to a case where only a color filter is used. An improvement degree of the light utilization efficiency and the color reproducibility may differ slightly depending on quantum efficiency and FWHM. However, when it is assumed that commonly sold quantum dots, for example, quantum dots having quantum efficiency of about 50% or more and an FWHM of about 55 nm or less are used, the organic light-emitting diode display device according to the present invention has light utilization efficiency improved by 15% or more and color reproducibility improved by 10% or more, as compared to those of an organic light-emitting diode display device not including quantum dot layers in the prior art.

In order to establish the aforementioned effects, emission spectra and color regions before and after light generated in an organic light-emitting device passes through a quantum dot layer were measured through a simulation.

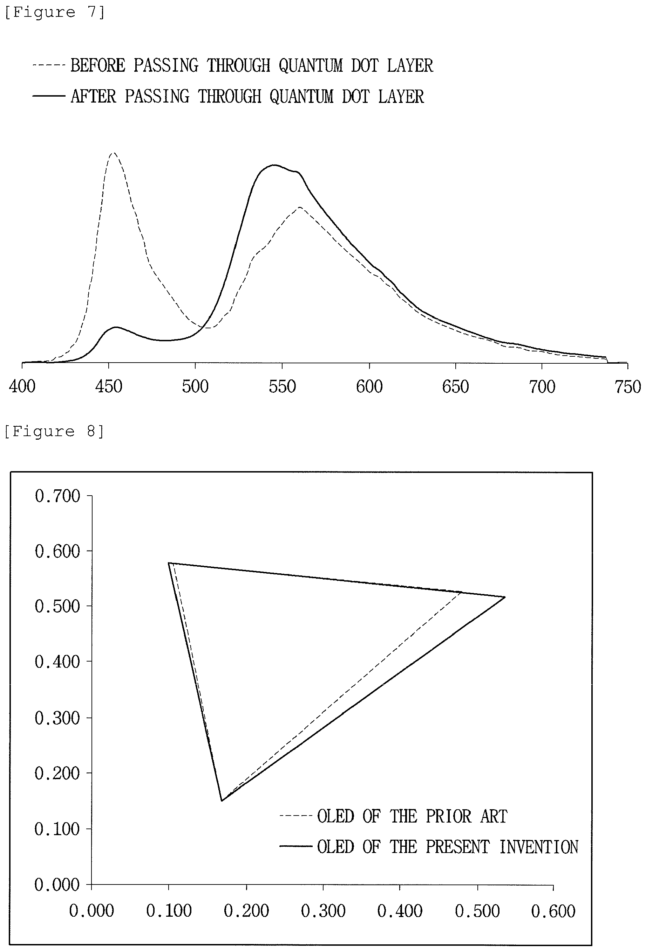

The measurement results of the emission spectra are shown in FIGS. 6 and 7, and the measurement results of the color regions are shown in FIG. 8. Specifically, FIG. 6 is a graph showing an emission spectrum comparison before and after the light generated in the organic light-emitting diode display device passes through a red quantum dot layer. FIG. 7 is a graph showing an emission spectrum comparison before and after the light generated in the organic light-emitting diode display device passes through a green quantum dot layer.

Referring to FIG. 6, it can be seen that as a wavelength of light emitted from the organic light-emitting device is changed to a red wavelength range of about 600 nm to about 700 nm after the light passes through the red quantum dot layer, light amount of a red wavelength range is considerable increased. Therefore, when the light passing through the red quantum dot layer are incident on a red color filter, a light amount absorbed by the red color filter is decreased and a light transmission amount is considerably increased. In addition, referring to FIG. 7, it can be seen that as the wavelength of the light emitted from the organic light-emitting device is changed to a green wavelength range of about 490 nm to about 560 nm after the light passes through a green quantum dot layer, a light amount of a red wavelength range is considerable increased. Therefore, when the light passing through the green quantum dot layer are incident on a green color filter, a light amount absorbed by the red color filter is decreased and a light transmission amount is considerably increased

On the other hand, referring to FIG. 8, since a color region of the organic light-emitting diode display device having a structure according to the present invention is wider than a color region of an organic light-emitting diode display device of the prior art, it can be seen that the organic light-emitting diode display device has excellent color reproducibility.

## Claims

1. An organic light-emitting diode display device including a plurality of picel regions each including a plurality of subpixels configured to implement light having different wavelength ranges, the organic light-emitting diode display device comprising:
a substrate provided with a thin film transistor;
an organic light-emitting device electrically connected to the thin film transistor and generating white light;
a color filter array comprising a plurality of color filters disposed at positions corresponding to the plurality of subpixels to selectively transmit light having a wavelength range corresponding to each of the plurality of subpixels; and
a quantum dot layer disposed between the organic light-emitting device and the color filter and converting incident light into light having a wavelength capable of passing through the color filter.

2. The organic light-emitting diode display device of claim 1, wherein each of the plurality of unit pixels comprises a red subpixel, a green subpixel, and a blue subpixel.

3. The organic light-emitting diode display device of claim 2, wherein an area of the blue subpixel is about 1.5 times to about 3 times larger than an area of the red subpixel and is about 1.1 times to about 2 times larger that an area of the green subpixel.

4. The organic light-emitting diode display device of claim 1, wherein each of the plurality of unit pixels comprises a red subpixel, a green subpixel, a blue subpixel, and a white subpixel.

5. The organic light-emitting diode display device of claim 4, wherein an area of the blue subpixel is about 1.5 times to about 3 times larger than an area of the red subpixel and is about 1.1 times to about 2 times larger that an area of the green subpixel, and
an area of the white subpixel is about 1.5 times to about 3 times larger than an area of the red subpixel.

6. The organic light-emitting diode display device of claim 1, wherein the plurality of color filters are disposed on a protective film of the thin film transistor.

7. The organic light-emitting diode display device of claim 1, wherein the plurality of color filters are disposed on an encapsulation layer of the organic light-emitting device.

8. The organic light-emitting diode display device of claim 1, wherein the quantum dot layer comprises at least one of a red quantum dot layer configured to convert blue light and green light into red light, and a green quantum dot layer configured to convert blue light into green light.

9. The organic light-emitting diode display device of claim 1, wherein the quantum dot layer is formed on a surface of the color filters.

10. The organic light-emitting diode display device of claim 1, wherein the organic light-emitting device is a top emission type organic light-emitting device.

11. The organic light-emitting diode display device of claim 1, wherein the organic light-emitting device is a bottom emission type light-emitting device.

12. An organic light-emitting diode display device including a plurality of unit pixels each including a red subpixel, a green subpixel, and a blue subpixel, the organic light-emitting diode display device comprising:
a substrate provided with a thin film transistor;
a bottom emission organic light-emitting device electrically connected to the thin film transistor and generating white light;
a color filter array disposed between the bottom emission organic light-emitting device and the thin film transistor and comprising a red color filter disposed at a position corresponding to the red subpixel, a green color filter disposed at a position corresponding to the red subpixel, and a blue color filter disposed at a position corresponding to the blue subpixel; and
a red quantum dot layer disposed between the red color filter and the bottom emission organic light-emitting device to convert incident light into light having a wavelength capable of passing through the red color filter, and a green quantum dot layer disposed between the green color filter and the bottom emission organic light-emitting device to convert incident light into light having a wavelength capable of passing through the green color filter.

13. An organic light-emitting diode display device including a plurality of unit pixels each including a red subpixel, a green subpixel, a blue subpixel, and a white subpixel, the organic light-emitting diode display device comprising:
a substrate provided with a thin film transistor;
a bottom emission organic light-emitting device electrically connected to the thin film transistor and generating white light;
a color filter array disposed between the bottom emission organic light-emitting device and the thin film transistor and comprising a red color filter disposed at a position corresponding to the red subpixel, a green color filter disposed at a position corresponding to the red subpixel, and a blue color filter disposed at a position corresponding to the blue subpixel; and
a red quantum dot layer disposed between the red color filter and the bottom emission organic light-emitting device to convert incident light into light having a wavelength capable of passing through the red color filter, and a green quantum dot layer disposed between the green color filter and the bottom emission organic light-emitting device to convert incident light into light having a wavelength capable of passing through the green color filter.

14. An organic light-emitting diode display device including a plurality of unit pixels each including a red subpixel, a green subpixel, and a blue subpixel, the organic light-emitting diode display device comprising:
a substrate provided with a thin film transistor;
a top emission organic light-emitting device electrically connected to the thin film transistor and generating white light;
a color filter array disposed between the top emission organic light-emitting device and the thin film transistor and comprising a red color filter disposed at a position corresponding to the red subpixel, a green color filter disposed at a position corresponding to the red subpixel, and a blue color filter disposed at a position corresponding to the blue subpixel; and
a red quantum dot layer disposed between the red color filter and the top emission organic light-emitting device to convert incident light into light having a wavelength capable of passing through the red color filter, and a green quantum dot layer disposed between the green color filter and the top emission organic light-emitting device to convert incident light into light having a wavelength capable of passing through the green color filter.

15. An organic light-emitting diode display device including a plurality of unit pixels each including a red subpixel, a green subpixel, a blue subpixel, and a white subpixel, the organic light-emitting diode display device comprising:
a substrate provided with a thin film transistor;
a top emission organic light-emitting device electrically connected to the thin film transistor and generating white light;
a color filter array disposed between the top emission organic light-emitting device and the thin film transistor and comprising a red color filter disposed at a position corresponding to the red subpixel, a green color filter disposed at a position corresponding to the red subpixel, and a blue color filter disposed at a position corresponding to the blue subpixel; and
a red quantum dot layer disposed between the red color filter and the top emission organic light-emitting device to convert incident light into light having a wavelength capable of passing through the red color filter, and a green quantum dot layer disposed between the green color filter and the top emission organic light-emitting device to convert incident light into light having a wavelength capable of passing through the green color filter.
